**Europäisches Patentamt**

**European Patent Office**

**Office européen des brevets**

(19)

(11) Veröffentlichungsnummer: **0 085 872**
**B1**

(12) # EUROPÄISCHE PATENTSCHRIFT

(45) Veröffentlichungstag der Patentschrift:
30.04.86

(21) Anmeldenummer: 83100538.4

(22) Anmeldetag: 21.01.83

(51) Int. Cl.⁴: **H 03 G 1/00, H 03 G 1/04**

(54) Integrierbarer Differenzverstärker.

(30) Priorität: 09.02.82 DE 3204430

(43) Veröffentlichungstag der Anmeldung:
17.08.83 Patentblatt 83/33

(45) Bekanntmachung des Hinweises auf die Patenterteilung:
30.04.86 Patentblatt 86/18

(84) Benannte Vertragsstaaten:
AT DE FR GB IT

(56) Entgegenhaltungen:
DE - A - 2 230 431
DE - A - 2 908 741
US - A - 3 706 937
US - A - 3 936 731

PATENTS ABSTRACTS OF JAPAN, Band 6, Nr. 189, 28.
September 1982, Seite (E-133) (1967)
IBM TECHNICAL DISCLOSURE BULLETIN, Band 15, Nr.
5, Oktober 1972, Seiten 1444-1445, New York, USA, C.C.
LIU: "Differential variable-gain amplifier"

(73) Patentinhaber: Siemens Aktiengesellschaft, Berlin und
München Wittelsbacherplatz 2, D-8000 München 2 (DE)

(72) Erfinder: Fenk, Josef, Dipl.-Ing.,
Deutenhauserstrasse 10, D-8057 Eching/Ottenburg (DE)

## Beschreibung

Die vorliegende Erfindung bezieht sich auf einen integrierbaren Differenzverstärker mit einer das Versorgungspotential sowie das Bezugspotential liefernden Gleichspannungsquelle, bei dem ein den eigentlichen Differenzverstärker bildender erster und zweiter Transistor mit ihrem Emitter gemeinsam an den Kollektor eines dritten Transistors gelegt sind, während ihre Basisanschlüsse je eine Signaleingangsklemme bilden und außerdem uber je einen Widerstand an ein gemeinsames erstes Hilfspotential gelegt sind, bei dem der Kollektor des ersten Transistors sowie der Kollektor des zweiten Transistors jeweils unter Vermittlung eines Lastwiderstandes an das Versorgungspotential angeschaltet und außerdem der dem ersten bzw. dem zweiten Transistor zugewandte Anschluß des zugehörigen Lastwiderstandes jeweils unmittelbar mit einer Signalausgangsklemme des Verstärkers verbunden ist und bei dem schließlich die Verbindung zwischen dem Emitter des ersten und des zweiten Transistors zum Bezugspotential über den Emitter des durch ein zweites Hilfspotential an seiner Basis beaufschlagten dritten Transistors erfolgt.

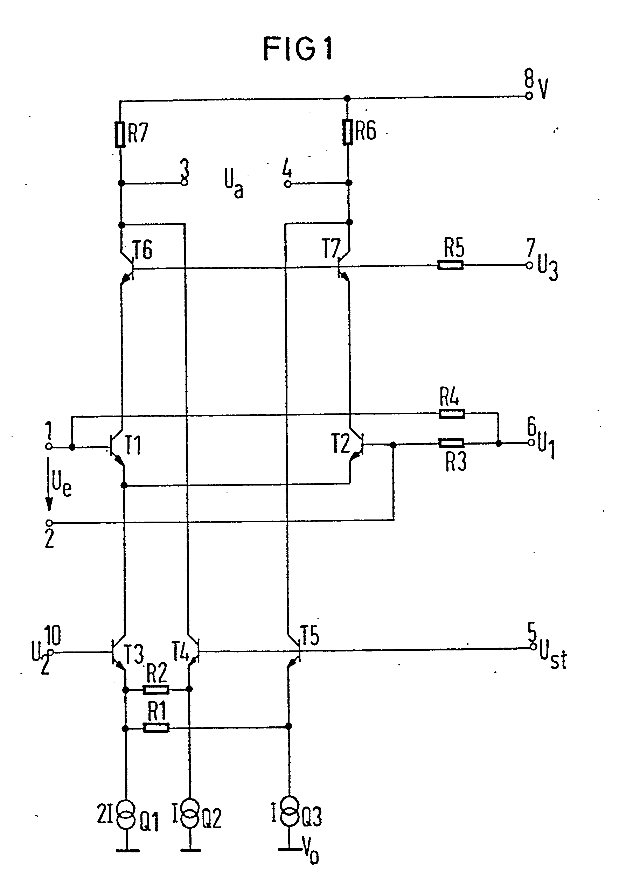

Ein solcher Differenzverstärker bildet z.B. den Kern einer Oszillatorschaltung entsprechend der Fig. 1 der am 12.05.1982 veröffentlichten europäischen Patentanmeldung 0 051 179. Zusätzlich zu der soeben gegebenen Definition ist bei diesem Differenzverstärker noch die Steuerung durch einen Schwingkreis bzw. Schwingquarz und eine Rückkopplung vorgesehen. Jedoch ist zu bemerken, daß ein solcher Differenzverstärker auch für die Signalverstärkung einegesetzt werden kann, wenn er dementsprechend gesteuert wird.

Differenzverstärker an den mit ihren Emittern gekoppelten Verstärkertransistoren mit einem eingeprägten Strom (Stromquelle) zu versorgen, ist ebenfalls der vorgenannten europäischen Patentanmeldung 0 051 179 entnehmbar, nach der dies über einen Widerstand erfolgt. Weiterhin ist dies auch mittels eines stromeinprägenden Transistorzweiges aus der DE-A-22 30 431 bekannt.

Aus der DE-A-29 08 741 ist die Möglichkeit des Steuerns eines Differenzverstärkers bekannt geworden, wonach über gesonderte Transistorzweige sowohl in den Ausgangskreis eines Transistorzweiges eines Differenzverstärkers als auch in den Kreis der gemeinsamen Emitter der beiden Differenzverstärker-Transistoren eingegriffen wird. Dabei wird jedoch keine symmetrische Differenzverstärkeranordnung erhalten.

Die Aufgabe, die der vorliegenden Erfindung zugrunde liegt, besteht darin, einen Verstärker anzugeben, der - bis in den UHF-Bereich hinein - eine maximale Verstärkung der jeweils angelegten Signale bei großem Regelumfang des Verstärkers liefert.

Um das Verlangte zu leisten, wird gemäß der vorliegenden Erfindung eine der eingangs gegebenen Definition enteprechende Verstärkerschaltung derart weiter ausgebildet, daß ein vierter und ein fünfter Transistor vorgesehen und die Emitter dieser beiden Transistoren sowie der Emitter des dritten Transistors über je eine Konstantstromquelle an das Bezugspotential angeschlossen sind, daß dabei der Basisanschluß des vierten und des fünften Transistors gemeinsam durch ein auf das Bezugspotential bezogenes Kontrollsignal beaufschlagt sind, daß außerdem der Emitter des vierten Transistors sowie der Emitter des fünften Transistors -z.B. über je einen Widerstand-mit dem Emitter des dritten Transistors verbunden ist, und daß schließlich der Kollektor des vierten Transistors in bezug auf den vom Kollektor des ersten Transistors gesteuerten Zweig sowie der Kollektor des fünften Transistors inbezug auf den vom zweiten Transistor gesteuerten Zweig des Differenzverstärkers derart an den Differenzverstärker angeschaltet ist, daß durch den Kollektorstrom des vierten Transistors der über den dem ersten Transistor zugeordneten Lastwiderstand und durch den Kollektorstrom des fünften Transistors der über den dem zweiten Transistor zugeordneten Lastwiderstand fließende Strom beeinflußt wird, und daß hierbei eine unmittelbare Verbindung zwischen den Kollektoren des vierten und des fünften Transistors mit den miteinander verbundenen Emittern des ersten und des zweiten Transistors nicht besteht.

Vorzugsweise ist dabei vorgesehen, daß zwischen dem Kollektor des ersten Transistors und der ihm zugeordneten Ausgangsklemme sowie zwischen dem Kollektor des zweiten Transistors und der ihm zugeordneten Ausgangsklemme je ein in Kaskodeschaltung betriebener sechster bzw.siebenter Transistor vorgesehen ist und daß beide Transistoren gemeinsam gesteuert sind.

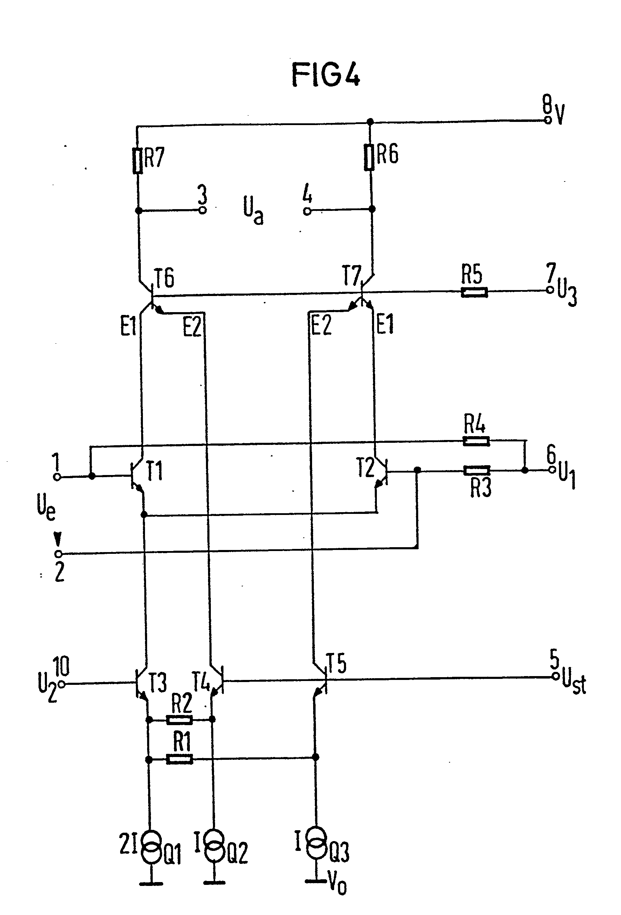

Die verschiedenen Möglichkeiten der Anschaltung des vierten und des fünften Transistors zur Beeinflussung des über die Lastwiderstände fließenden Stromes und damit der Ausgangssignale ist in den Figuren 1 - 4 dargestellt, anhand deren die Erfindung näher beschrieben werden soll. In allen diesen Fällen ist die soeben genannte Kaskodestufe vorgesehen. Sie kann jedoch - abgesehen von dem in Fig. 4 dargestellten Fall - entfallen. Allerdings ist zu bemerken, daß die Anwesenheit der Kaskodestufe merklich zu einer weiteren Verbesserung des erfindungsgemäßen Verstärkers beiträgt.

Jede der vier Figuren stellt ein Schaltbeispiel des erfindungsgemäßen Verstärkers dar. In allen Figuren sind übereinstimmende Bezugszeichen verwendet. Außerdem ist die Ausführung dieser Schaltungen so getroffen, daß sämtliche Transistoren vom npn-Typ sind. Eine Realisierung mit pnp-Transistoren ist jedoch ebenfalls möglich. Schließlich könnten anstelle der Bipolartransistoren auch MOS-Feldeffekttransistoren, z.B. selbstsperrende npn-Kanaltransistoren verwendet werden.

Bei den in den vier Figuren dargestellten Schaltungen für den erfindungsgemäßen Verstärker besteht der den Kern der Schaltung bildende Differenzverstärker aus den beiden Transistoren T1 und T2, deren Emitter unmittelbar miteinander verbunden sind. Die Basis des einen Transistors T1 liegt sowohl an der Signaleingangsklemme 1 als auch über einen Widerstand R4 an der Klemme 6 für ein erstes Hilfspotential $U_1$. Die Basis des zweiten Transistors T2 liegt an der zweiten Eingangsklemme 2 für ein zu verstärkendes Eingangssignal $U_e$ und außerdem über einen Widerstand R3 an dem soeben genannten ersten Hilfspotential $U_1$. Das Hilfspotential $U_1$ ist ebenso wie die übrigen Hilfspotentiale $U_2$, $U_3$ und das Kontrollsignal $U_{st}$ auf das Bezugspotential $V_o$ (Masse) bezogen und kann, z.B. durch den einen Pol einer weiteren Gleichspannungsquelle, deren anderer Pol am Bezugspotential $U_o$ liegt, gegeben sein. Auch eine Ableitung der Hilfspotentiale, z.B. durch Spannungsteilung der durch die erste Versorgungsspannungsquelle (in den Figuren nicht dargestellt) gelieferten und durch das Bezugspotential $V_o$ und das andere Versorgungspotential V definierten Versorgungsspannung ist möglich.

Der Emitter des ersten Transistors und der Emitter des zweiten Transistors, d.h. also die Emitter der Transistoren T1 und T2 liegen am Kollektor des durch das zweite Hilfspotential $U_2$ am Eingang 10 beaufschlagten dritten Transistors T3, dessen Emitter mit dem Ausgang einer ersten Konstantstromquelle Q1 verbunden ist. Der Emitter des dritten Transistors ist außerdem über einen Widerstand RI mit dem Emitter des fünften Transistors T5 und der Emitter des vierten Transistors T4 über den Widerstand R2 mit dem Emitter des ersten Transistors T1 verbunden. Gegebenenfalls kann aber auch die Verbindung zwischen dem Emitter des ersten Transistors T1 und den Emittern des vierten und fünften Transistors T4 und T5 unmittelbar erfolgen.

Der Emitter des vierten Transistors T4 und der Emitter des fünften Transistors T5 liegen über je eine Konstantstromquelle Q2 bzw. Q3 am Bezugspotential $V_o$. Die Konstantstromquellen Q1, Q2 und Q3 können z.B. durch je einen in bekannter Weise als Konstantstromquelle geschalteten npn-Transistor gegeben sein. Eine andere Möglichkeit besteht darin, daß man die einzelnen Stromquellen Q1, Q2 und Q3 durch übliche Stromspiegelschaltungen ersetzt.

Wie aus den Figuren ersichtlich ist, ist zur Versorgung des dritten Transistors T3 die Konstantstromquelle Q1 und zur Versorgung des vierten und des fünften Transistors T4 und T5 die Konstantstromquelle Q2 und Q3 so ausgelegt, daß die Konstantstromquelle Q2 und die Konstantstromquelle Q3 jeweils denselben Strom I an den zugehörigen Transistor T4 bzw. T5 abgibt, während der Strom, den der dritte Transistor T3 von der ihm zugeordneten Konstantstrom quelle Q1 erhält, doppelt so groß ist. Der dritte Transistor T3 ist zudem, wie bereits bemerkt, an seiner Basis durch das zweite Hilfspotential $U_2$ gesteuert, während die Basisanschlüsse des vierten und des fünften Transistors T4 und T5 gemeinsam durch ein auf das Bezugspotential $V_o$ bezogenes Kontrollsignal $U_{st}$ gesteuert sind.

Die Kollektoren der beiden den eigentlichen Differenzverstärker bildenden Transistoren, also des ersten Transistors T1 und des zweiten Transistors T2, liegen im ein-fachsten Fall, wie bereits oben festgestellt, unmittelbar an je einer Ausgangsklemme 3 bzw. 4, sowie über je einen Lastwiderstand R7 bzw. R6 am Versorgungspotential V, das an die Versorgungsklemme 8 angelegt ist.

Bei den in den Figuren 1 bis 4 dargestellten Ausführungsformen eines erfindungsgemäßen Verstärkers liegt hingegen der Kollektor des ersten Transistors T1 am Emitter eines Transistors T6 und der Kollektor des zweiten Transistors T2 des Differenzverstärkers am Emitter eines Transistors T7, die eine Kaskodenstufe bilden und gemeinsam an ihrer Basis von einer dritten Hilfsspannung $U_3$ über die Klemme 7 beaufschlagt sind. Bevorzugt erfolgt die Steuerung des sechsten Transistors T6 und des siebenten Transistors T7 über einen gemeinsamen Widerstand R5. Bei Anwesenheit der beiden Transistoren T6 und T7 wird nicht der Kollektor des ersten Transistors T1 und des zweiten Transistors T2 sondern der Kollektor des sechsten Transistors T6 einerseits und der Kollektor des siebenten Transistors T7 andererseits einerseits an je eine der Ausgangsklemmen 3 bzw. 4 zwecks Erzeugung der Ausgangsspannung $U_a$ gelegt und andererseits mit je einem Widerstand R6 bzw. R7 mit der Klemme 8 für das Versorgungspotential V verbunden.

Wichtig für die Erfindung ist nun, daß der Kollektor des vierten Transistors T4 und der Kollektor des fünften Transistors T5 derart mit je einem der beiden Zweige des Differenzverstärkers zusammengeschaltet ist, daß durch deren Wirkung das Ausgangssignal $U_a$ an den Klemmen 3 und 4 eine Verbesserung erhält, die bei Abwesenheit der beiden Transistoren T4 und T5 nicht gegeben ist. Hierzu ist auch wichtig, daß keine unmittelbare Verbindung zwischen den Kollektoren des vierten Transistors T4 und des fünften Transistors T5 und dem Kollektor des dritten Transistors T3 und damit mit den miteinander gekoppelten Emittern der beiden Transistoren T1 und T2 des Differenzverstärkers nicht besteht, wie dies auch bei der Definition der Erfindung angegeben ist.

Bei der in Figur 1 dargestellten Ausführungsform eines Verstärkers gemäß der Erfindung ist der Kollektor des vierten Transistors T4 mit dem Kollektor des sechsten Transistors T6 und damit mit der Ausgangsklemme 3 verbunden, während der Kollektor des fünften Transistors T5 mit dem Kollektor des siebenten Transistors T7 und damit mit der Ausgangsklemme 4 unmittelbar verbunden ist.

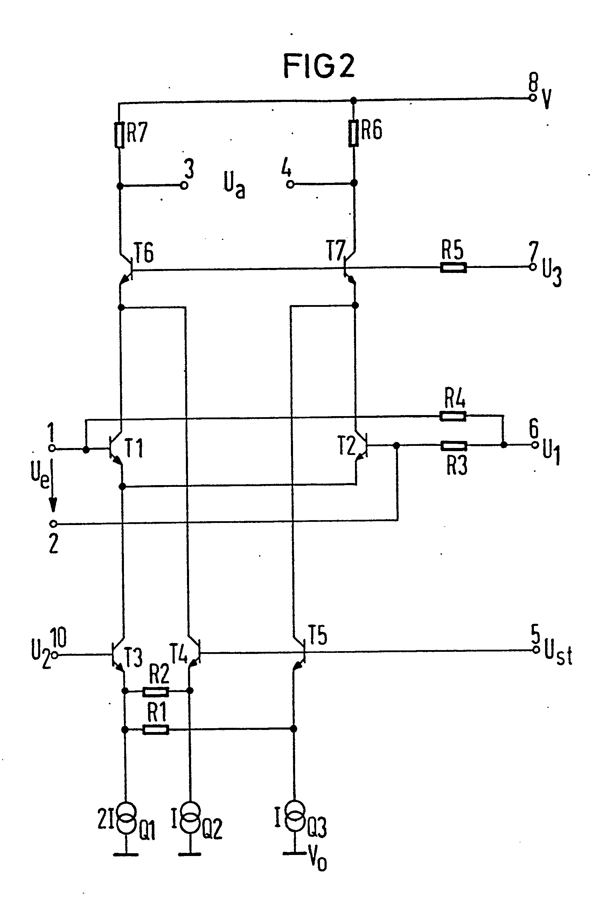

Bei der in Figur 2 dargestellten Schaltung ist eine Steuerung des Ausgangssignals mittels des vierten Transistors T4 und des fünften Transistors T5 dadurch möglich, indem der Kollektor des ersten Transistors T1 mit dem Kollektor vierten Transistors T4 und der Kollektor des zweiten Transistors T2 des Differenzverstärkers mit dem Kollektor des fünften Transistors T5 unmittelbar verbunden ist.

Damit wird der Emitter des sechsten Transistors T6 bzw. des siebenten Transistors T7 gleichzeitig durch den Kollektor des ersten Transistors T1 und des vierten Transistors T4 bzw. durch den Kollektor des zweiten Transistors T2 und des fünften Transistors T5 beaufschlagt.

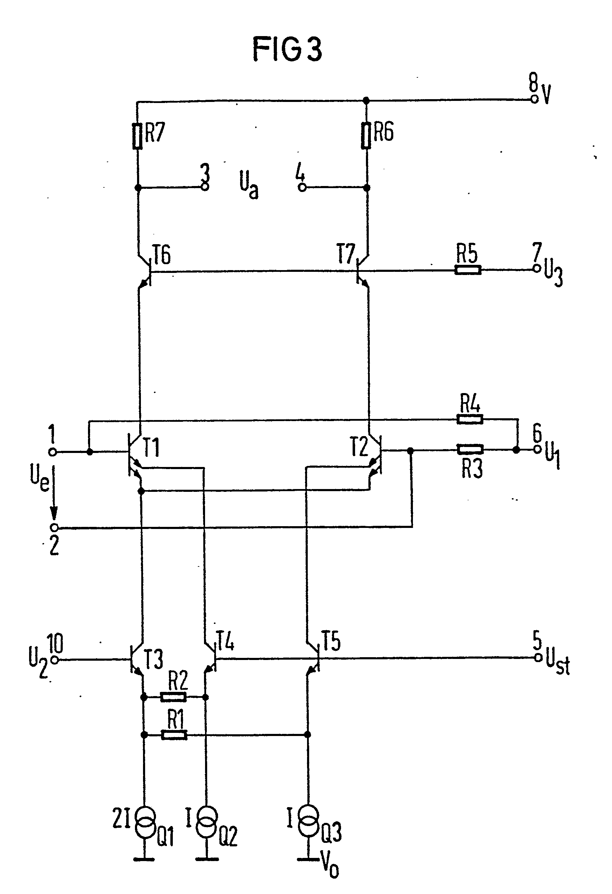

Bei der in Figur 3 dargestellten Variante ist der erste Transistor T1 und der zweite Transistor T2 jeweils als Zwei-Emitter-Transistor ausgebildet. Dies ermöglicht, daß je ein Emitter des ersten und des zweiten Transistors T1 und T2 durch den Kollektor des Transistors T3 in der für Differenzverstärker üblichen Weise gemeinsam versorgt werden, während der zweite Emitter des ersten Transistors T1 mit dem Kollektor des vierten Transistors T4 und der zweite Emitter des zweiten Transistors T2 mit dem Kollektor des fünften Transistors T5 verbunden ist.

Bei der günstigsten Lösung gemäß Figur 4 ist anstelle der beiden ersten Transistoren Tl und T2 der sechste und der siebente Transistor, also der Transistor T6 und der Transistor T7 mit jeweils zwei Emittern versehen, wobei ein Emitter des sechsten Transistors T6 vom Kollektor des ersten Transistors Tl und der zweite Emitter des sechsten Transistors T6 vom Kollektor des vierten Transistors T4 beaüfschlagt ist. Ebenso liegt der erste Emitter des siebenten Transistors T7 am Kollektor des zweiten Transistors T2 und der andere Emitter von T7 am Kollektor des fünften Transistors T5.

Aufgrund der der Definition der Erfindung entsprechenden und insbesondere den Ausgestaltungen gemäß Fig. 1 bis 4 gemäß ausgestalteten Schaltungen ergibt sich folgendes Verhalten:

Wird ein symmmetrisches, insbesondere hochfrequentes Nutzsignal $U_e$ an den Eingangsklemmen 1 und 2 angelegt, so erhält man an den Ausgangsklemmen 3 und 4 das durch den ersten Transistor Tl, durch den zweiten Transistor T2 und bei Anwesenheit des sechsten und siebenten Transistors T6 und T7 durch diese zusätzlich verstärkte Ausgangssignal $U_a$. Die maximale Verstärkung erhält man im Falle der Ausgestaltung der erwähnten Transistoren T1 - T7 und Q1- Q3 als npn-Transistoren dann, wenn die das Kontrollsignal $U_{st}$ führende Klemme 5 negativer als die das zweite Hilfspotential $U_2$ an die Basis des dritten Transistors T3 legende Klemme 10 (bezogen auf Masse, also das Hilfspotential $V_o$)) ist, und außerdem der dritte Transistor T3 den Gesamtstrom aller Stromquellen Q1, Q2 und Q3 leitet. Die Emitter des ersten Transistors T1 und des zweiten Transistors T2 sind möglichst niederohmig (d.h.

mit einem Minimum an ohmschen Widerstand) miteinander verbunden, um keine merkliche Emitter-Gegenkopplung zu erhalten. Da der Realteil der Ausgangsadmittanz des ersten Transistors T1 und des zweiten Transistors T2 bei hohen Frequenzen relativ niederohmig ist und den zulässigen Last-Widerstand parasitär reduzieren würde, ist die durch den sechsten Transistors T6 gegebene Kaskodestufe und die durch den siebenten Transistor T7 gegebene Kaskodestufe aufgrund der auch in den Figuren 1- 4 verwendete Weiterbildung der Erfindung vorgesehen, wobei der Ausgangswiderstand der beiden Kaskodestufen T6 und T7 wesentlich größer als der der Lastwiderstände R6 und R7 bemessen ist. Außerdem reduziert die durch den sechsten Transistor T6 und die durch den siebenten Transistor T7 gegebene Kaskodestufe die Rückkopplung zwischen den Ausgangsanschlüssen 3 und 4 auf den Eingang 1 und 2 und erhöht die maximale Verstärkung. Der das dritte Hilfspotential $U_3$ über die Klemme 7 an die Basisanschlüsse der beiden Kaskodetransistoren T6 und T7 weiterleitende Widerstand R5 ist zwar nicht unbedingt erforderlich; er bringt jedoch eine Verbesserung der Symmetrie des an den Klemmen 3 und 4 erhaltenen Ausgangssignals $U_a$ bedingt durch den Widerstand R5.

Wird an die Basisanschlüsse des vierten und des fünften Transistors T4 und T5 eine Kontrollspannung $U_{st}$ derart angelegt, daß der Stromfluß über den vierten und über den fünften Transistor T4 bzw. T5 gerade einsetzt, so wird dadurch einerseits die hochfrequente Verstärkung auf dem Weg vom Signaleingang 1, 2 zum Signalausgang 3, 4 reduziert und andererseits der Gleichstrom-Arbeitspunkt an den Ausgangsklemmen 3 und 4 nicht beeinflußt, da der vom dritten Transistor T3 abgeleitete Strom über die Kollektoren des vierten Transistors T4 und des fünften Transistors T5 aufgrund jeder der Erfindung genügenden Schaltung wieder auf den den vierten und fünften Transistor T4 und T5 kollektorseitig mit dem Versor ungspotential V verbindenden Lastwiderstand R7 bzw. R6 fließt.

Alle der Erfindung entsprechenden und vor allem den in Figur 1 bis 4 dargestellten Ausführungsformen gemäßen Verstärkerschaltungen haben gegenüber den bekannten Verstärkerschaltungen den Vorteil, daß aufgrund der direkten Emitterverkopplung zwischen dem ersten Transistor T1 und dem zweiten Transistor T2 die aufgrund einer Differenzverstärkerschaltung maximal mögliche Verstärkung erzielbar ist, wobei der Gleichspannungs-Arbeitspunkt an den Anschlüssen 3 und 4 unabhängig von der Steuerspannung $U_{st}$ am Anschluß 5 konstant bleibt. Durch die Kaskodetransistoren T6 und T7 wird hinsichtlich der Verstärkung des Ausgangssignals $U_a$ eine weitere Verbesserung erreicht.

Aufgrund der in Figur 3 bzw. Fig. 4 gemäß der Erfindung ausgestalteten Verstärkerschaltung wird vor allem auch erreicht, daß die Kollektorausgänge des vierten und des fünften Transistors T4 und T5 nicht im hochfrequenten Signalweg in der Verstärkerschaltung liegen, was bei den Schaltungen gemäß Fig. 1 und 2 ersichtlich nicht der Fall ist, so daß sich bei einer Schaltung gemäß Fig. 3 und 4 die Transistoren T4 und T5 sich nicht als verstärkungsmindernd auswirken können.

Die in Fig. 3 dargestellte Möglichkeit ist nicht ganz so günstig wie die in Fig. 4 dargestellte Möglichkeit, weil eine parasitäre Verkopplung über die Kollektor-Basis-Kapazität des vierten und des fünften Transistors T4 und T5 im Gegensatz zu einer Schaltung gemäß Fig. 4 nicht völlig ausgeschlossen werden kann. Dies bedingt, daß die maximale Verstärkung im Falle einer Schaltung gemäß Fig. 3 nicht ganz so groß wie im Falle einer Schaltung gemäß Fig. 4 ist. Außerdem kann auch die Eingangsimpedanz bei einer Schaltung gemäß Fig. 3 leichter als im Falle einer Schaltung gemäß Fig. 4 störend beeinflußt werden.

Auch die in Fig. 2 dargestelite Schaltung ist weniger optimal als die Schaltung gemäß Fig. 4, weil die Kollektoren des vierten und des fünften Transistors T4 bzw. T5 direkt an den zwar niederohmigen aber das HF-Signal führenden Emitteranschlüssen des sechsten und des siebenten Transistors T6 und T7 liegen. Dabei beeinflußt die parasitär wirkende Admittanz der Kollektoranschlüsse des vierten und des fünften Transistors T4 bzw. T5 die HF-Verstärkereigenschaften im Vergleich zu der Ausgestaltung gemäß Fig. 4 etwas im ingünstigen Sinne.

Was schließlich noch die in Fig. 1 dargestellte Ausbildung betrifft, so ist im Vergleich zu der Ausgestaltung gemäß Fig. 4 festzustellen, daß die parasitär wirkende Admittanz der Kollektoranschlüsse des vierten und des fünften Transistors T4 und T5 ebenfalls - im Gegensatz zu einer Schaltung gemäß Fig. 4 - verstärkungsmindernd auf das am hochohmigen Ausgang 3 und 4 auftretende Ausgangssignal $U_a$ einwirkt.

**Patentansprüche**

1.) Integrierbarer Differenzverstärker mit einer das Versorgungs potential (V) sowie das Bezugspotential ($V_o$) liefernden Gleichspannungsquelle, bei dem ein den eigentlichen Differenzverstärker bildender erster und zweiter Transistor(T1,T2) mit ihrem Emitter gemeinsam an den Kollektor eines dritten Transistors (T3) gelegt sind, während ihre Basisanschlüsse je eine Signaleingangsklemme (1,2) bilden und außerdem über je eine Widerstand (R3,R4) an ein gemeinsames erstes Hilfspotential (U1) gelegt sind, bei dem der Kollektor des ersten Transistors (T1) sowie der Kollektor des zweiten Transistors (T2) jeweils unter Vermittlung enes Lastwiderstandes (R7,R6) an das Versorgungspotential (V) angeschaltet und außerdem der dem ersten bzw. dem zweiten Transistor (T1,T2) zugewandte Anschluß des zugehörigen Lastwiderstandes (R7,R6) jeweils unmittelbar mit je einer Signalausgangsklemme (3,4) des Verstärkers verbunden ist und bei dem schließlich die Verbindung zwischen dem Emitter des ersten und des zweiten Transistors (T1,T2) zum Bezugspotential ($V_o$ über den Emitter des durch ein zweites Hilfspotential (U2) an seiner Basis beaufschlagten dritten Transistors (T3) erfolgt, dadurch gekennzeichnet, daß ein vierter und ein fünfter Transistor (T4, T5) vorgesehen und die Emitter dieser beiden Transistoren (T4,T5) sowie der Emitter des dritten Transistors (T3) über je eine Konstantstromquelle (Q1, Q2, Q3) an das Bezugspotential ($V_o$) angeschlossen sind, daß dabei der Basisanschluß des vierten und des fünften Transistors (T4, T5) gemeinsam durch ein auf das Bezugspotential ($V_o$) bezogenes Kontrollsignal ($U_{st}$) beaufschlagt sind, daß außerdem der Emitter des vierten Transistors (T4) sowie der Emitter des fünften Transistors (T5) - z.B. über je einen Widerstand (R1, R2) - mit dem Emitter des dritten Transistors (T3) verbunden ist, und daß schließlich der Kollektor des vierten Transistors (T4) inbezug auf den vom Kollektor des ersten Transistors (T1) gesteuerten Zweig sowie der Kollektor des fünften Transistors (T5) inbezug auf den vom zweiten Transistor (T2) gesteuerten Zweig des Differenzverstärkers (Tl, T2) derart an den Differenzverstärker angeschaltet ist, daß durch den Kollektorstrom des vierten Transistors (T4) der über den dem ersten Transistor zugeordneten Lastwiderstand (R7) und durch den Kollektorstrom des fünften Transistors (T5) der über den dem zweiten Transistor (T2) zugeordneten Lastwiderstand (R6) fließende Strom beeinflußt wird, und daß hierbei eine unmittelbare Verbindung zwischen den Kollektoren des vierten und des fünften Transistors (T4, T5) mit den miteinander verbundenen Emittern des ersten und des zweiten Transistors (T1, T2) nicht besteht.

2.) Verstärker nach Anspruch 1, dadurch gekennzeichnet, daß zwischen dem Kollektor des ersten Transistors (T1) und der ihm zugeordneten Ausgangsklemme(3) sowie zwischen dem Kollektor des zweiten Transistors (T2) und der ihm zugeordneten Ausgangsklemme des - insbesondere durchwegs mit npn-Transistoren realisierten-Differenzverstärkers je ein in Kaskodeschaltung betriebener sechster bzw. siebenter Transistor (T6,T7) vorgesehen und daß beiden Transistoren (T6, T7) durch ein drittes Hilfspotential ($U_3$) - insbesondere unter Vermittlung eines gemeinsamen Widerstands (R5) - gesteuert sind.

3.) Verstärker nach Anspruch 2, dadurch gekennzeichnet, daß der Kollektor des sechsten Transistors (T6) mit dem Kollektor des vierten Transistors (T4) sowie der Kollektor des siebenten Transistors (T7) mit dem Kollektor des fünften Transistors (T5) verbunden ist (Fig. 1).

4.) Verstärker nach einem der Ansprüche 1 bis 3, dadurch gekennzeichnet, daß der Kollektor des vierten Transistors (T4) mit dem Kollektor des ersten Transistors (T1) sowie der Kollektor des fünften Transistors (T5) mit dem Kollektor des zweiten Transistors (T2) verbunden ist (Fig. 2).

5.) Verstärker nach Anspruch 1 oder 2, dadurch gekennzeichnet, daß der erste Transistor (T1) sowie der zweite Transistors (T2) jeweils mit zwei Emittern versehen und der zweite Emitter des ersten Transistors (T1) für die Beaufschlagung durch den Kollektor des vierten Transistors (T4) sowie der zweite Emitter des zweiten Transistors (T2) für die Beaufschlagung durch den Kollektor des fünften Transistors (T5) vorgesehen ist (Fig. 3).

6.) Verstärker nach einem der Ansprüche 2 bis 5, dadurch gekennzeichnet, daß der sechste Transistor (T6) sowie der siebente Transistor (T7) jeweils mit zwei Emittern versehen und dabei der zweite Emitter des sechsten Transistors (T6) für die Beaufschlagung durch den Kollektor des vierten Transistors (T4) und der zweite Emitter des siebenten Transistors (T7) für die Beaufschlagung durch den fünften Transistor (T5) vorgesehen ist (Fig.4).

**Claims:**

1. An integratable differential amplifier with a d.c. voltage source which supplies the supply potential (V) and the reference potential ($V_o$), wherein a first and second transistor (T1, T2) each have their emitters connected to a common collector of a third transistor (T3) whilst their respective base electrodes serve as separate signal input terminals (1,2), each further connected via a respective resistor (R3, R4) to a common first auxiliary potential (U1), to form the actual differential amplifier, wherein the collector of the first transistor (T1) and the collector of the second transistor (T2) are each connected via a load resistor (R7, R6) to the supply potential (V), and in addition that terminal of the load resistors (R7, R6) adjacent the associated first or second transistor (T1, T2) respectively is in each case directly connected to a signal output terminal (3,4) of the amplifier, and wherein finally the connection between the emitters of the first and second transistors (T1, T2) to the reference potential ($V_o$) takes place via the emitter of the third transistor (T3) which has a second auxiliary potential (U2) applied to its base, characterised in that a fourth and a fifth transistor (T4, T5) are provided and the emitters of these two transistors (T4, T5) and the emitter of the third transistor (T3) are each connected via a respective constant current source (Q1, Q2, Q3) to the reference potential ($V_o$), that a common control signal ($U_{st}$) relative to the reference potential ($V_o$) is applied to the base electrodes of the fourth and fifth transistors (T4, T5) that moreover the emitter of the fourth transistor (T4) and the emitter of the fifth transistor (T5) are each connected - for example via respective resistors (R1, R2) - to the emitter of the third transistor (T3), and that finally the collector of the fourth transistor (T4), in relation to that arm of the differential amplifier (T1, T2) which is controlled by the collector of the first transistor (T1), and the collector of the fifth transistor (T5), in relation to that arm of the differential amplifier (T1, T2) which is controlled by the second transistor (T2), are connected to the differential amplifier in such manner that the current flowing across the load resistor (R7) which is assigned to the first transistor is influenced by the collector current of the fourth transistor (T4), and the current flowing across the load resistor (R6) which is assigned to the second transistor (T2) is influenced by the collector current of the fifth transistor (T5), and that there is no direct connection between the collectors of the fourth and fifth transistors (T4, T5) and the interconnected emitters of the first and second transistors (T1, T2).

2. An amplifier as claimed in Claim 1, characterised in that a sixth transistor is arranged between the collector of the first transistor (T1) and the output terminal (3) assigned thereto, and a seventh transistor (T7) is arranged between the collector of the second transistor (T2) and the output terminal assigned thereto, the differential amplifier being constructed by npn-transistors, and that the two transistors (T6, T7) are controlled by a third auxiliary potential ($U_3$), in particular via a common resistor (R5).

3. An amplifier as claimed in Claim 2, characterised in that the collector of the sixth transistor (T6) is connected to the collector of the fourth transistor (T4), and the collector of the seventh transistor (T7) is connected to the collector of the fifth transistor (T5) (Fig. 1).

4. An amplifier as claimed in one of the Claims 1 to 3, characterised in that the collector of the fourth transistor (T4) is connected to the collector of the first transistor (T1), and the collector of the fifth transistor (T5) is connected to the collector of the second transistor (T2) (Fig. 2).

5. An amplifier as claimed in Claim 1 or 2, characterised in that the first transistor (T1) and the second transistor (T2) are each provided with two emitters, and the second emitter of the first transistor-(T1) is coupled to the collector of the fourth transistor (T4), whereas the second emitter of the second transistor (T2) is coupled to the collector of the fifth transistor (T5) (Fig. 3).

6. An amplifier as claimed in one of the Claims 2 to 5, characterised in that the sixth transistor (T6) and the seventh transistor (T7) are each provided with two emitters, and the second emitter of the sixth transistor (T6) is coupled to the collector of the fourth transistor (T4), whereas the second emitter of the seventh transistor (T7) is coupled to the fifth transistor (T5) (Fig. 4).

## Revendications

1. Amplificateur différentiel intégrable, avec une source de tension continue fournissant le potentiel d'alimentation (V) ainsi que le potentiel de reférence (V$_o$), dans lequel un premier et un second transistor tT1, T2) qui forment l'amplificateur différentiel proprement dit, sont reliés par leur émetteur et en commun, au collecteur d'un troisième transistor (T3), alors que chacune de leurs bornes de base forme une borne d'entrée des signaux (1, 2), et sont, en outre, reliées respectivement par une résistance (R3, R4) à un premier potentiel auxiliaire commun (U1), dans lequel le collecteur du premier transistor (T1) ainsi que le collecteur du second transistor (T2) sont reliés chacun, et par l'intermédiaire d'une résistance de charge (R7, R6), au potentiel d'alimentation (V) et qu'en outre la borne de la résistance de charge (R7, R6) associée, qui est voisine du premier, respectivement du second transistor (T1, T2) est reliée à une borne de sortie des signaux (3, 4) de l'amplificateur, et dans lequel, finalement, la liaison entre l'émetteur du premier et du second transistor (T1, T2) et le potentiel de référence (V$_o$) a lieu par l'intermédiaire de l'émetteur du troisième transistor (T3), dont la base est chargée par un second potentiel auxiliaire (U2), caractérisé par le fait qu'il est prévu un quatrième et un cinquième transistor (T4, T5) dont les émetteurs de ces deux transistors (T4, T5), ainsi que l'émetteur du troisième transistor (T3) sont reliés chacun par l'intermédiaire d'une source de courant constant (Ql, Q2, Q3) au potentiel de référence (V$_o$), que ce faisant, la borne de base du quatrième et du cinquième transistor (T4, T5) sont chargées en commun par un signal de contrôle (U$_{st}$) rapporté au potentiel de référence (V$_o$) qu'en outre l'émetteur du quatrième transistor (T4) de même que l'émetteur du cinquième transistor (T5) sont reliés -par exemple par une résistance respective (R1, R2)- à l'émetteur du troisième transistor (T3), et que finalement le collecteur du quatrième transistor (T4) est relié, relativement à la branche commandée par le collecteur du premier transistor (T1) et le collecteur du cinquième transistor (T5), est relié, relativement à la branche de l'amplificateur différentiel (T1, T2) commandée par le second transistor (T2). de telle manière à l'amplificateur différentiel que par le courant de collecteir du quatrième transistor (T4) est influencé le courant qui passe par la résistance de charge (R7) qui est associé au premier transistor et que par le courant de collecteur du cinquième transistor (T5) est influencé le courant qui passe par la résistance de charge (R6) qui est associé au second transistor (T2), et que de ce fait il n'existe pas de liaison directe entre les collecteurs du quatrième et du cinquième transistor (T4, T5) avec les émetteurs, reliés entre eux, du premier et du second transistor (T1, T2).

2. Amplificateur selon la revendication 1, caractérisé par le fait qu'il est prévu, entre le collecteur du premier transistor (T1) et la borne de sortie (3) qui lui est associée, de même qu'entre le collecteur du second transistor (T2) et la borne de sortie qui lui est associée, de l'amplificateur différentiel réalisée en particulier uniquement avec des transistors npn- respectivement un sixième et un septième transistor (T6, T7) en montage en cascade, et que les deux transistors (T6, T7) sont commandés par un troisième potentiel auxiliaire (U$_3$), en particulier à travers une résistance commune (R5).

3. Amplificateur selon la revendication 2, caractérisé par le fait que le collecteur du sixième transistor (T6) est relié au collecteur du quatrième transistor (T4), de même que le collecteur du septième transistor (T7) est relié au collecteur du cinquième transistor (T5) (figure 1).

4. Amplificateur selon l'une des revendications 1 à 3, caractérisé par le fait que le collecteur du quatrième transistor (T4) est relié au collecteur du premier transistor (T1), alors que le collecteur du cinquième transistor (T5) est relié au collecteur du second transistor (T2) (figure 2).

5. Amplificateur selon la revendication 1 ou 2, caractérisé par le fait que le premier transistor (T1), de même que le second transistor (T2) sont chacun pourvus de deux émetteurs, et le second émetteur du premier transistor (T1) est prévu pour être chargé par le collecteur du quatrième transistor (T4), alors que le second émetteur du second transistor (T2) est prévu pour être chargé par le collecteur du cinquième transistor (T5) (figure 3).

6. Amplificateur selon l'une des revendications 2 à 5, caractérisé par le fait que le sixième transistor (T6) ainsi que le septième transistor (T7), sont chacun pourvus de deux émetteurs, le second émetteur du sixième transistor (T6) étant prévu pour être chargé par le collecteur du quatrième transistor (T4), alors que le second émetteur du septième transistor (T7) est prévu pour être chargé par le cinquième transistor (T5) (figure 4).

# FIG 1

# FIG 2

# FIG 3

# FIG 4